# EUROPEAN PATENT APPLICATION

(11) **EP 4 268 998 A1**
(43) Date of publication of application: **01.11.2023**
(21) Application number: 21914938.2
(22) Date of filing: 29.06.2021
(51) Int. Cl.: B22F 7/04, B22F 9/00, B22F 9/24, H05K 1/09, H05K 3/12, B22F 1/00

(54) **METHOD FOR PRODUCING COMPOSITE MATERIAL**

(30) Priority: 28.12.2020 JP 2020219529
(71) Applicant: Kao Corporation, Chuo-ku Tokyo 103-8210 (JP)
(72) Inventor: YOSHIDA, Tomohide, Wakayama-shi, Wakayama 640-8580 (JP); EYAMA, Takaaki, Wakayama-shi, Wakayama 640-8580 (JP)
(74) Representative: Hoffmann Eitle
(86) International application number: PCT/JP2021/024454
(87) International publication number: WO 2022/145076

(57) **Abstract**

The present invention relates to a method of producing a composite material including a substrate and a metal film formed on the substrate, including a step of coating a metallic fine particle-containing ink on the substrate to form a metal film on the substrate, the substrate having a heat resisting temperature of 130°C or less, the metallic fine particle-containing ink containing metallic fine particles A dispersed with a polymer B, the metallic fine particles A having a volume average particle diameter D_{A} of 10 to 60 nm, the metal film having a cross-sectional porosity of 2 to 30% by area, and the metal film having a content of a metal of 90% by mass or more.

## Description

### Field of the Invention

The present invention relates to a method of producing a composite material, and a device using a composite material obtained by the production method.

### Background of the Invention

Metallic fine particles can form a metal film having conductivity through sintering, and therefore have been used for the formation of a circuit and an electrode in various electronic components, and a conductive use, such as bonding components.

For example, JP 2008-004375 A (PTL 1) intends to provide a conductivity exhibiting method and the like which method can provide a high conductivity without necessity of a sintering step which has been required, and describes a conductivity exhibiting method and the like, in which method, metallic ultrafine particles dispersed as a metallic colloid in water and/or an organic solvent are reacted with a compound having a halogen in the molecule through ionic bond, so as to provide a conductivity on a substrate.

### Summary of the Invention

The present invention relates to a method of producing a composite material including a substrate and a metal film formed on the substrate, including
a step of coating a metallic fine particle-containing ink on the substrate to form a metal film on the substrate,
the substrate having a heat resisting temperature of 130°C or less,
the metallic fine particle-containing ink containing metallic fine particles A dispersed with a polymer B, the metallic fine particles A having a volume average particle diameter D_{A} of 10 nm or more and 60 nm or less,
the metal film having a cross-sectional porosity of 2% by area or more and 30% by area or less, and
the metal film having a content of a metal of 90% by mass or more.

### Detailed Description of the Invention

An ink containing metallic fine particles can form a metal film reflecting light, and thus is used for claims various images in metallic colors for a decorative use, in addition to the conductive use described above. However, the metal film formed is liable to suffer oxidation and sulfurization due to the influence of oxygen and sulfur compounds in the air, and the hue of the metal film may be changed in some cases. Accordingly, there is a demand of the suppression of the hue change of the metal film.

There is a tendency in recent years that a resin film substrate, such as a PET film, is used as a substrate for forming the metal film. However, the substrate of this type has a low heat resistance, and the metal film cannot be formed through high temperature sintering of metallic fine particles. Accordingly, there is a demand of a composite material including a metal film that suffers a less hue change with low temperature sintering.

The metal film stored under a high temperature and high humidity condition may suffer electrochemical migration, i.e., deposition of the metal on a portion other than the portion having the metal film formed thereon, and there is a demand of a composite material including a metal film that is suppressed in occurrence of electrochemical migration under a high temperature and high humidity condition.

However, the technique of PTL 1 is insufficient in suppression of the hue change of the metal film formed through sintering of metallic fine particles, and is also insufficient in suppression of electrochemical migration under a high temperature and high humidity condition.

The present invention relates to a method of producing a composite material capable of forming a metal film that suffers less hue change, and is suppressed in occurrence of electrochemical migration under a high temperature and high humidity condition, even in the case where the metal film is formed on a substrate having a low heat resistance, and also relates to a device using a composite material obtained by the production method.

The present inventors have focused on the fact that the dispersion stability of the metallic fine particles can be enhanced, and a favorable metal film having less residual components other than the metal, such as the dispersant and the solvent, in the metal film can be formed, in such a manner that a step of coating a metallic fine particle-containing ink on the substrate having a heat resisting temperature of the prescribed value or less to form a metal film on the substrate is included, the metallic fine particle-containing ink contains metallic fine particles dispersed with a polymer, the metallic fine particles have a volume average particle diameter in the prescribed range, the metal film has a cross-sectional porosity in the prescribed range, and the metal film having a content of a metal of the prescribed value or more, and have found that a method of producing a composite material capable of forming a metal film that suffers less hue change, and is suppressed in occurrence of electrochemical migration under a high temperature and high humidity condition, even in the case where the metal film is formed on a substrate having a low heat resistance, and a device using a composite material obtained by the production method can be provided thereby.

Specifically, the present invention relates to the following items [1] and [2].
[1] A method of producing a composite material including a substrate and a metal film formed on the substrate, including
   a step of coating a metallic fine particle-containing ink on the substrate to form a metal film on the substrate,
   the substrate having a heat resisting temperature of 130°C or less,
   the metallic fine particle-containing ink containing metallic fine particles A dispersed with a polymer B, the metallic fine particles A having a volume average particle diameter D_{A} of 10 nm or more and 60 nm or less,
   the metal film having a cross-sectional porosity of 2% by area or more and 30% by area or less, and
   the metal film having a content of a metal of 90% by mass or more.
[2] A device including a composite material produced by the production method described in the item [1].

The present invention can provide a method of producing a composite material capable of forming a metal film that suffers less hue change, and is suppressed in occurrence of electrochemical migration under a high temperature and high humidity condition, even in the case where the metal film is formed on a substrate having a low heat resistance, and a device using a composite material obtained by the production method.

### [Method of producing Composite Material]

The method of producing a composite material of the present invention is a method of producing a composite material including a substrate and a metal film formed on the substrate, including a step of coating a metallic fine particle-containing ink on the substrate to form a metal film on the substrate, in which the substrate has a heat resisting temperature of 130°C or less, the metallic fine particle-containing ink contains metallic fine particles A dispersed with a polymer B, the metallic fine particles A have a volume average particle diameter D_{A} of 10 nm or more and 60 nm or less, the metal film has a cross-sectional porosity of 2% by area or more and 30% by area or less, and the metal film has a content of a metal of 90% by mass or more.

The present invention exhibits an effect of being capable of forming a metal film that suffers less hue change, and is suppressed in occurrence of electrochemical migration under a high temperature and high humidity condition, even in the case where the metal film is formed on a substrate having a low heat resistance. The mechanism therefor is not clear, but can be estimated as follows.

It is considered that a metal film having less residual components other than the metal, such as the dispersant and the solvent, in the metal film can be formed irrespective of low temperature sintering due to the low heat resistance of the substrate since the metallic fine particle-containing ink used in the present invention contains metallic fine particles dispersed with a polymer as a dispersant, and the volume average particle diameter of the metallic fine particles is in the prescribed range. Furthermore, it is considered that the surface area inside the metal film is reduced since the cross-sectional porosity of the metal film formed is in the prescribed range, and the content of the metal in the metal film is the prescribed value or more. As a result, it is considered that a composite material including a metal film that is suppressed in hue change can be obtained.

In the present invention, furthermore, it is considered that the reduced content of the residual components other than the metal, such as a dispersant and a solvent, in the metal film formed can suppress the ionization of the metal component caused through the affinity between the components, such as a dispersant and a solvent, and the metal component, and can suppress the acceleration of electrochemical migration under high temperature and high humidity condition, and thereby a composite material including a metal film that is suppressed in occurrence of electrochemical migration can be obtained.

### <Metallic Fine Particle-containing Ink>

The metallic fine particle-containing ink according to the present invention contains metallic fine particles A dispersed with a polymer B from the standpoint of the regulation of the volume average particle diameter of the metallic fine particles to the desired range, the reduction of the hue change of the metal film, and the suppression of the occurrence of electrochemical migration.

### (Metallic Fine Particles A)

Examples of the metal (metal atom) constituting the metallic fine particles A include a Group 4 transition metal, such as titanium and zirconium; a Group 5 transition metal, such as vanadium and niobium; a Group 6 transition metal, such as chromium, molybdenum, and tungsten; a Group 7 transition metal, such as manganese, technetium, and rhenium; a Group 8 transition metal, such as iron and ruthenium; a Group 9 transition metal, such as cobalt, rhodium, and iridium; a Group 10 transition metal, such as nickel, palladium, and platinum; a Group 11 transition metal, such as copper, silver, and gold; a Group 12 transition metal, such as zinc and cadmium; a Group 13 metal, such as aluminum, gallium, and indium; and a Group 14 metal, such as germanium, tin, and lead. One kind of the metal constituting the metallic fine particles A may be used as a single metal, or two or more kinds thereof may be used in combination as an alloy. Among these, the metal constituting the metallic fine particles A preferably contains a transition metal of the Groups 4 to 11 in the 4th to 6th Periods, more preferably contains copper, nickel, and a noble metal, such as gold, silver, platinum, and palladium, further preferably contains at least one kind selected from the group consisting of gold, silver, copper, nickel, and palladium, still further preferably contains at least one kind selected from the group consisting of gold, silver, copper, and nickel, still more further preferably contains at least one kind selected from the group consisting of silver, copper, and nickel, even further preferably contains at least one kind selected from the group consisting of silver and nickel, even still further preferably contains silver, and even still more further preferably is silver, from the standpoint of the conductivity, the standpoint of the decoration capability, and the standpoint of the reduction of the hue change of the metal film, and the suppression of the occurrence of electrochemical migration. The kinds of the metals can be confirmed by the high frequency induction coupled plasma emission spectroscopy.

The total content of silver, cooper, and nickel in the metallic fine particles A is preferably 80% by mass or more, more preferably 90% by mass or more, further preferably 95% by mass or more, still further preferably 98% by mass or more, and still more further preferably substantially 100% by mass, from the standpoint of the enhancement of the storage stability of the dispersion, and the reduction of the resistivity of the metal film.

The total content of silver and nickel in the metallic fine particles A is preferably 80% by mass or more, more preferably 90% by mass or more, further preferably 95% by mass or more, still further preferably 98% by mass or more, and still more further preferably substantially 100% by mass, from the standpoint of the enhancement of the storage stability of the dispersion, and the reduction of the resistivity of the metal film.

The content of silver in the metallic fine particles A is preferably 80% by mass or more, more preferably 90% by mass or more, further preferably 95% by mass or more, still further preferably 98% by mass or more, and still more further preferably substantially 100% by mass, from the standpoint of the enhancement of the storage stability of the dispersion, and the reduction of the resistivity of the metal film.

The expression "substantially 100% by mass" herein means that a component that is unintentionally contained may be contained. Examples of the component that is unintentionally contained include an unavoidable impurity.

The volume average particle diameter D_{A} of the metallic fine particles A is 10 nm or more, preferably 20 nm or more, and more preferably 30 nm or more, and is 60 nm or less, preferably 50 nm or less, and more preferably 40 nm or less, from the standpoint of the enhancement of the dispersion stability of the metallic fine particles, the reduction of the residual components in the metal film, the reduction of the hue change of the metal film, and the suppression of the occurrence of electrochemical migration.

The volume average particle diameter D_{A} can be measured according to the method described in the examples.

The volume average particle diameter D_{A} of the metallic fine particles A can be regulated by the kind and the metal reduction rate of the metallic fine particles, the kind and the amount of the dispersant, the production condition of the metallic fine particle-containing ink, such as the reduction temperature, and the like.

In the case where the metallic fine particle-containing ink is produced by a method of mixing a metal raw material compound, a reducing agent, and the polymer B as the dispersant, so as to reduce the metal raw material compound, for example, the volume average particle diameter D_{A} can be regulated by a method of regulating the mixing amount of the polymer B with respect to the metal raw material compound, so as to regulate the mass ratio ((polymer B)/((metallic fine particles A)+(polymer B))) in the ink, a method of regulating the temperature of the reduction reaction of the metal raw material compound, and the like.

The content of the metallic fine particles A in the metallic fine particle-containing ink according to the present invention is preferably 2% by mass or more, more preferably 5% by mass or more, further preferably 10% by mass or more, still further preferably 20% by mass or more, and still more further preferably 30% by mass or more, and is preferably 85% by mass or less, more preferably 70% by mass or less, further preferably 60% by mass or less, and still further preferably 50% by mass or less, from the standpoint of the conductivity, the standpoint of the decoration capability, the standpoint of the dispersion stability of the metallic fine particles in the ink, and the standpoint of the reduction of the residual components in the metal film, the reduction of the hue change of the metal film, and the suppression of the occurrence of electrochemical migration.

### (Polymer B)

The metallic fine particles A according to the present invention are dispersed with a polymer B from the standpoint of the enhancement of the dispersion stability of the metallic fine particles, the reduction of the residual components in the metal film, the reduction of the hue change of the metal film, and the suppression of the occurrence of electrochemical migration. The polymer B is not particularly limited, as far as having a function of dispersing the metallic fine particles, and preferably contains a hydrophilic group. The polymer B more preferably has the hydrophilic group on the side chain thereof.

Examples of the hydrophilic group include an anionic group, for example, a group exhibiting acidity by releasing a hydrogen ion through dissociation, such as a carboxy group (-COOM), a sulfonic acid group (-SOsM), and a phosphoric acid group (-OPO₃M₂), and ionic forms thereof formed through dissociation, (such as - COO⁻, ⁻SO₃⁻, -OPO₃²⁻, and -OPOs M); a cationic group, for example, a protonic acid group, such as a primary, secondary, or tertiary amino group, and a quaternary ammonium group; and a nonionic group, such as a polyoxyalkylene group, a hydroxy group, and an amido group. In the chemical formulae above, M represents a hydrogen atom, an alkali metal, ammonium, or an organic ammonium.

In the case where the polymer B has an anionic group, the anionic group is preferably a carboxy group. In this case, examples of the basic structure of the polymer B include a vinyl-based polymer, such as an acrylic-based resin, a styrene-based resin, a styrene-acrylic-based resin, and an acrylic silicone-based resin; and a condensation-based polymer, such as a polyester and a polyurethane.

In the case where the polymer B has a nonionic group, examples of the polymer B include a polymer having a polyoxyalkylene group, a polymer having a structure derived from vinylpyrrolidone, such as polyvinylpyrrolidone, a polymer having a structure derived from acrylamide, such as polyacrylamide, and a polyvinyl alcohol.

The polymer B preferably has at least one kind selected from the group consisting of a carboxy group and a polyoxyalkylene group, and more preferably contains at least a carboxy group, from the standpoint of the enhancement of the dispersion stability of the metallic fine particles, the reduction of the residual components in the metal film, the reduction of the hue change of the metal film, and the suppression of the occurrence of electrochemical migration.

The polymer B is preferably a vinyl-based polymer containing a constitutional unit derived from a monomer (b-1) having a carboxy group from the same standpoint as above.

The vinyl-based polymer is preferably a homopolymer composed of a constitutional unit derived from the monomer (b-1) or a copolymer containing a constitutional unit derived from the monomer (b-1) and a constitutional unit derived from a monomer other than the monomer (b-1). In the case where the vinyl-based polymer is a copolymer, the vinyl-based polymer may be any of a block copolymer, a random copolymer, and an alternating copolymer.

### [Monomer (b-1) having Carboxy Group]

The carboxy group contained in the monomer (b-1) is as described above.

Specific examples of the monomer (b-1) include an unsaturated monocarboxylic acid, such as (meth)acrylic acid, crotonic acid, and 2-methacryloyloxymethyl succinate; and an unsaturated dicarboxylic acid, such as maleic acid, itaconic acid, fumaric acid, and citraconic acid. The unsaturated dicarboxylic acid may be an anhydride.

One kind of the monomer (b-1) may be used alone, and two or more kinds thereof may be used in combination.

The monomer (b-1) is preferably at least one kind selected from the group consisting of (meth)acrylic acid and maleic acid, and more preferably (meth)acrylic acid, from the standpoint of the enhancement of the dispersion stability of the metallic fine particles, the reduction of the residual components in the metal film, the reduction of the hue change of the metal film, and the suppression of the occurrence of electrochemical migration.

In the specification, the "(meth)acrylic acid" means at least one kind selected from the group consisting of acrylic acid and methacrylic acid. The "(meth)acrylic acid" in the following specification has the same meaning.

### [Monomer (b-2) having Polyoxyalkylene Group]

The polymer B is preferably a vinyl-based polymer containing a constitutional unit derived from the monomer (b-1) having a carboxy group and a constitutional unit derived from a monomer (b-2) having a polyoxyalkylene group from the standpoint of the enhancement of the dispersion stability of the metallic fine particles, the reduction of the residual components in the metal film, the reduction of the hue change of the metal film, and the suppression of the occurrence of electrochemical migration.

The monomer (b-2) is preferably a monomer capable of introducing a polyoxyalkylene group to the side chain of the vinyl-based polymer from the same standpoint as above. Examples of the monomer (b-2) include a polyalkylene glycol (meth)acrylate, an alkoxypolyalkylene glycol (meth)acrylate, and a phenoxypolyalkylene glycol (meth)acrylate. One kind of the monomer (b-2) may be used alone, or two or more kinds thereof may be used in combination. In the specification, the "(meth)acrylate" means at least one kind selected from the group consisting of acrylate and methacrylate. The "(meth)acrylate" in the following specification has the same meaning.

The monomer (b-2) is preferably at least one kind selected from the group consisting of a polyalkylene glycol (meth)acrylate and an alkoxypolyalkylene glycol (meth)acrylate, and more preferably an alkoxypolyalkylene glycol (meth)acrylate, from the standpoint of the enhancement of the dispersion stability of the metallic fine particles, the reduction of the residual components in the metal film, the reduction of the hue change of the metal film, and the suppression of the occurrence of electrochemical migration. The number of carbon atoms of the alkoxy group of the alkoxypolyalkylene glycol (meth)acrylate is preferably 1 or more and 8 or less, and more preferably 1 or more and 4 or less, from the same standpoint as above.

Examples of the alkoxypolyalkylene glycol (meth)acrylate include a methoxypolyalkylene glycol (meth)acrylate, an ethoxypolyalkylene glycol (meth)arylate, a propoxypolyalkylene glycol (meth)acrylate, a butoxypolyalkylene glycol (meth)acrylate, and an octoxypolyalkylene glycol (meth)acrylate.

The polyoxyalkylene group of the monomer (b-2) preferably contains a unit derived from an alkylene oxide having 2 or more and 4 or less carbon atoms from the standpoint of the enhancement of the dispersion stability of the metallic fine particles, the reduction of the residual components in the metal film, the reduction of the hue change of the metal film, and the suppression of the occurrence of electrochemical migration. Examples of the alkylene oxide include ethylene oxide, propylene oxide, and butylene oxide. Among these, the polyoxyalkylene group of the monomer (b-2) more preferably contains at least one kind selected from the group consisting of a unit derived from ethylene oxide and a unit derived from propylene oxide, and further preferably contains a unit derived from ethylene oxide.

The number of the unit derived from an alkylene oxide in the polyoxyalkylene group is preferably 2 or more, and more preferably 5 or more, and is preferably 100 or less, more preferably 70 or less, further preferably 50 or less, still further preferably 30 or less, and still more further preferably 15 or less, from the standpoint of the enhancement of the dispersion stability of the metallic fine particles, the reduction of the residual components in the metal film, the reduction of the hue change of the metal film, and the suppression of the occurrence of electrochemical migration.

The polyoxyalkylene group may be a copolymer containing a unit derived from ethylene oxide and a unit derived from propylene oxide. The molar ratio (EO/PO) of the unit (EO) derived from ethylene oxide and the unit (PO) derived from propylene oxide is preferably 60/40 or more, more preferably 65/35 or more, and further preferably 70/30 or more, and is preferably 90/10 or less, more preferably 85/15 or less, and further preferably 80/20 or less, from the standpoint of the enhancement of the dispersion stability of the metallic fine particles, the reduction of the residual components in the metal film, the reduction of the hue change of the metal film, and the suppression of the occurrence of electrochemical migration.

The copolymer containing a unit derived from ethylene oxide and a unit derived from propylene oxide may be any of a block copolymer, a random copolymer, and an alternating copolymer.

Specific examples of the monomer (b-2) that is commercially available include NK Ester AM-90G, ditto AM-130G, ditto AMP-20GY, NK Ester M-20G, ditto 40G, ditto 90G, and ditto 230G, and the like, all available from Shin-Nakamura Chemical Co., Ltd., and Blemmer PE-90, ditto 200, ditto 350, and the like, Blemmer PME-100, ditto 200, ditto 400, ditto 1000, ditto 4000, and the like, Blemmer PP-500, ditto 800, ditto 1000, and the like, Blemmer AP-150, ditto 400, ditto 550, and the like, Blemmer 50PEP-300, Blemmer 50POEP-800B, and Blemmer 43PAPE-600B, all available from NOF Corporation.

### [Hydrophobic Monomer (b-3)]

The polymer B is preferably a vinyl-based polymer further containing a constitutional unit derived from a hydrophobic monomer (b-3) from the standpoint of the enhancement of the dispersion stability of the metallic fine particles, the reduction of the residual components in the metal film, the reduction of the hue change of the metal film, and the suppression of the occurrence of electrochemical migration.

In the specification, the "hydrophobic monomer" means that in the case where the monomer is dissolved in 100 g of ion exchanged water at 25°C to reach saturation, the dissolved amount thereof is less than 10 g.

Examples of the hydrophobic monomer (b-3) include an aromatic group-containing monomer and a (meth)acrylate having a hydrocarbon group derived from an aliphatic alcohol.

The aromatic group-containing monomer is preferably a vinyl monomer having an aromatic group having 6 or more and 22 or less carbon atoms, which may have a substituent containing a hetero atom, and more preferably one or more kind selected from the group consisting of a styrene-based monomer and an aromatic group-containing (meth)acrylate. The molecular weight of the aromatic group-containing monomer is preferably less than 500.

Examples of the styrene-based monomer include styrene, α-methylstyrene, 2-methylstyrene, 4-vinyltoluene (4-methylstyrene), and divinylbenzene, and styrene and α-methylstyrene are preferred from the standpoint of the enhancement of the dispersion stability of the metallic fine particles, the reduction of the residual components in the metal film, the reduction of the hue change of the metal film, and the suppression of the occurrence of electrochemical migration.

The aromatic group-containing (meth)acrylate is preferably phenyl (meth)acrylate, benzyl (meth)acrylate, phenoxyethyl (meth)acrylate, and the like, and more preferably benzyl (meth)acrylate.

The (meth)acrylate having a hydrocarbon group derived from an aliphatic alcohol preferably has a hydrocarbon group derived from an aliphatic alcohol having 1 or more and 22 or less carbon atoms from the standpoint of the enhancement of the dispersion stability of the metallic fine particles, the reduction of the residual components in the metal film, the reduction of the hue change of the metal film, and the suppression of the occurrence of electrochemical migration. Examples thereof include a (meth)acrylate having a linear alkyl group, such as methyl (meth)acrylate, ethyl (meth)acrylate, propyl (meth)acrylate, butyl (meth)acrylate, pentyl (meth)acrylate, octyl (meth)acrylate, decyl (meth)acrylate, dodecyl (meth)acrylate, and stearyl (meth)acrylate; a (meth)acrylate having a branched alkyl group, such as isopropyl (meth)acrylate, isobutyl (meth)acrylate, tert-butyl (meth)acrylate, isopentyl (meth)acrylate, isooctyl (meth)acrylate, isodecyl (meth)acrylate, isododecyl (meth)acrylate, isostearyl (meth)acrylate, and 2-ethylhexyl (meth)acrylate; and a (meth)acrylate having an alicyclic alkyl group, such as cyclohexyl (meth)acrylate.

The contents (which each are a content in terms of the non-neutralized amount, hereinafter the same) of the monomers in the raw material monomers in the production of the polymer B or the contents of the constitutional units derived from the monomers in the polymer B are as follows from the standpoint of the enhancement of the dispersion stability of the metallic fine particles, the reduction of the residual components in the metal film, the reduction of the hue change of the metal film, and the suppression of the occurrence of electrochemical migration.

The content of the monomer (b-1) is preferably 1% by mass or more, more preferably 2% by mass or more, and further preferably 3% by mass or more, and is preferably 30% by mass or less, more preferably 20% by mass or less, further preferably 10% by mass or less, still further preferably 8% by mass or less, and still more further preferably 5% by mass or less.

The content of the monomer (b-2) is preferably 5% by mass or more, more preferably 10% by mass or more, further preferably 20% by mass or more, and still further preferably 30% by mass or more, and is preferably 60% by mass or less, more preferably 55% by mass or less, further preferably 50% by mass or less, and still further preferably 45% by mass or less.

The content of the monomer (b-3) is preferably 30% by mass or more, more preferably 40% by mass or more, and further preferably 50% by mass or more, and is preferably 90% by mass or less, more preferably 80% by mass or less, and further preferably 70% by mass or less.

The mass ratio ((monomer (b-3))/((monomer (b-1)+(monomer (b-2)))) of the content of the constitutional unit derived from the monomer (b-3) with respect to the total content of the constitutional unit derived from the monomer (b-1) and the constitutional unit derived from the monomer (b-2) in the polymer B is preferably 0.5 or more, more preferably 0.7 or more, further preferably 1.0 or more, and still further preferably 1.3 or more, and is preferably 5.0 or less, more preferably 3.0 or less, further preferably 2.0 or less, and still further preferably 1.7 or less.

The polymer B used may be a polymer that is synthesized according to the known method, and may be a commercially available product. Examples of the commercially available product of the polymer B include DISPERBYK-190 and ditto 2015, all available from BYK Chemie GmbH.

The polymer B is preferably a vinyl-based polymer containing a constitutional unit derived from (meth)acrylic acid as the monomer (b-1) and a constitutional unit derived from an alkoxypolyalkylene glycol (meth)acrylate as the monomer (b-2), and more preferably a vinyl-based polymer containing a constitutional unit derived from (meth)acrylic acid as the monomer (b-1), a constitutional unit derived from an alkoxypolyethylene glycol (meth)acrylate as the monomer (b-2), and a constitutional unit derived from at least one kind selected from the group consisting of styrene and a styrene derivative as the monomer (b-3), from the standpoint of the enhancement of the dispersion stability of the metallic fine particles, the reduction of the residual components in the metal film, the reduction of the hue change of the metal film, and the suppression of the occurrence of electrochemical migration.

The number average molecular weight Mn of the polymer B is preferably 1,000 or more, more preferably 3,000 or more, further preferably 5,000 or more, and still further preferably 7,000 or more, and is preferably 100,000 or less, more preferably 50,000 or less, further preferably 30,000 or less, still further preferably 20,000 or less, and still more further preferably 15,000 or less. In the case where the number average molecular weight of the polymer B is in the range, the dispersion stability of the metallic fine particles can be enhanced, the residual components in the metal film can be reduced, the hue change of the metal film can be reduced, and the occurrence of electrochemical migration can be suppressed.

The number average molecular weight Mn can be measured according to the method described in the examples.

The acid value of the polymer B is preferably 5 mgKOH/g or more, more preferably 10 mgKOH/g or more, and further preferably 15 mgKOH/g or more, and is preferably 200 mgKOH/g or less, more preferably 100 mgKOH/g or less, further preferably 70 mgKOH/g or less, still further preferably 50 mgKOH/g or less, and still more further preferably 30 mgKOH/g or less, from the standpoint of the enhancement of the dispersion stability of the metallic fine particles, the reduction of the residual components in the metal film, the reduction of the hue change of the metal film, and the suppression of the occurrence of electrochemical migration.

The acid value of the polymer B can be calculated from the mass ratio of the monomers constituting the polymer. The acid value of the polymer B may also be obtained by titrating the polymer dissolved or swollen in a suitable solvent.

The existence mode of the polymer B in the metallic fine particle-containing ink according to the present invention includes a mode in which the polymer B is adsorbed to the metallic fine particles A, a mode of metallic fine particle-including capsules in which the polymer B contains the metallic fine particles A, and a mode in which the polymer B is not adsorbed to the metallic fine particles A. The mode in which the polymer B contains the metallic fine particles A is preferred, and the mode of metallic fine particle-including capsules in which the polymer B contains the metallic fine particles A is more preferred, from the standpoint of the dispersion stability of the metallic fine particles.

The content of the polymer B in the metallic fine particle-containing ink according to the present invention is preferably 0.5% by mass or more, more preferably 0.7% by mass or more, further preferably 1.0% by mass or more, still further preferably 1.3% by mass or more, and still more further preferably 1.5% by mass or more, and is preferably 10% by mass or less, more preferably 8.5% by mass or less, further preferably 7% by mass or less, still further preferably 5% by mass or less, still more further preferably 3% by mass or less, and even further preferably 2.5% by mass or less, from the standpoint of the enhancement of the dispersion stability of the metallic fine particles, the reduction of the residual components in the metal film, the reduction of the hue change of the metal film, and the suppression of the occurrence of electrochemical migration.

The mass ratio ((polymer B)/((metallic fine particles A)+(polymer B))) of the content of the polymer B with respect to the total content of the metallic fine particles A and the polymer B in the metallic fine particle-containing ink of the present invention is preferably 0.01 or more, more preferably 0.02 or more, further preferably 0.025 or more, still further preferably 0.03 or more, and still more further preferably 0.035 or more, and is preferably 0.2 or less, more preferably 0.15 or less, further preferably 0.1 or less, still further preferably 0.07 or less, and still more further preferably 0.05 or less, from the standpoint of the enhancement of the dispersion stability of the metallic fine particles, the reduction of the residual components in the metal film, the reduction of the hue change of the metal film, and the suppression of the occurrence of electrochemical migration.

The mass ratio ((polymer B)/((metallic fine particles A)+(polymer B))) is calculated from the content of the metallic fine particles A and the content of the polymer B in the metallic fine particle-containing ink measured according to the method described in the examples using a simultaneous thermogravimetry/differential thermal analyzer (TG/DTA).

### (Organic Solvent C)

The metallic fine particle-containing ink according to the present invention preferably further contains an organic solvent C having a boiling point of 70°C or more from the standpoint of the handleability of the ink, and the standpoint of the enhancement of the dispersion stability of the metallic fine particles, the reduction of the residual components in the metal film, the reduction of the hue change of the metal film, and the suppression of the occurrence of electrochemical migration. One kind of the organic solvent C may be used alone, or two or more kinds thereof may be used in combination.

The boiling point of the organic solvent C is preferably 70°C or more, more preferably 90°C or more, further preferably 110°C or more, still further preferably 130°C or more, and still more further preferably 150°C or more, and is preferably 300°C or less, more preferably 250°C or less, further preferably 230°C or less, and still further preferably 200°C or less, from the same standpoint as above. In the case where two or more kinds of the organic solvent C are used in combination, the boiling point of the organic solvent C is calculated as a weighted average value weighted by the contents (% by mass) of the organic solvents.

Examples of the organic solvent C include a polyhydric alcohol, a polyhydric alcohol alkyl ether, a nitrogen-containing heterocyclic compound, an amine, an amide, and a sulfur-containing compound. Among these, a polyhydric alcohol is preferred from the same standpoint as above.

The polyhydric alcohol is not particularly limited, as far as the compound has two or more alcoholic hydroxy groups in one molecule. Examples of the polyhydric alcohol include a 1,2-alkanediol, such as ethylene glycol (boiling point: 197°C), propylene glycol (1,2-propanediol) (boiling point: 188°C), 1,2-butanediol (boiling point: 193°C), 1,2-pentanediol (boiling point: 206°C), and 1,2-hexanediol (boiling point: 223°C); a polyalkylene glycol, such as diethylene glycol (boiling point: 245°C), triethylene glycol (boiling point: 287°C), tetraethylene glycol (boiling point: 314°C), polyethylene glycol, dipropylene glycol (boiling point: 232°C), and tripropylene glycol (boiling point: 271°C); an α,ω-alkanediol, such as 1,3-propanediol (boiling point: 210°C), 1,4-butanediol (boiling point: 230°C), and 1,5-pentanediol (boiling point: 242°C); a diol, such as 1,3-butanediol (boiling point: 208°C), 3-methyl-1,3-butanediol (boiling point: 203°C), and 2-methyl-2,4-pentanediol (boiling point: 196°C); and a triol, such as glycerin.

The organic solvent C preferably contains at least one kind selected from the group consisting of a diol and a triol, more preferably contains at least one kind selected from the group consisting of a 1,2-alkanediol, a polyalkylene glycol, an α,ω-alkanediol, and glycerin, further preferably contains at least one kind selected from the group consisting of a 1,2-alkanediol, an α,ω-alkanediol, and glycerin, still further preferably is at least one kind selected from the group consisting of ethylene glycol, propylene glycol, 1,4-butanediol, and glycerin, still more further preferably is at least one kind selected from the group consisting of ethylene glycol and propylene glycol, and even further preferably is propylene glycol, from the standpoint of the handleability of the ink, and the standpoint of the enhancement of the dispersion stability of the metallic fine particles, the reduction of the residual components in the metal film, the reduction of the hue change of the metal film, and the suppression of the occurrence of electrochemical migration.

The total content of a 1,2-alkanediol, a polyalkylene glycol, an α,ω-alkanediol, and glycerin in the polyol C is preferably 80% by mass or more, more preferably 90% by mass or more, further preferably 95% by mass or more, and still further preferably 98% by mass or more, and still more further preferably substantially 100% by mass, from the standpoint of the handleability of the ink, and the standpoint of the enhancement of the dispersion stability of the metallic fine particles, the reduction of the residual components in the metal film, the reduction of the hue change of the metal film, and the suppression of the occurrence of electrochemical migration. The expression "substantially 100% by mass" herein means that a component that is unintentionally contained may be contained. Examples of the component that is unintentionally contained include the polyol C component other than a 1,2-alkanediol, a polyalkylene glycol, an α,ω-alkanediol, and glycerin contained in the polyol as the raw material.

The content of the organic solvent C in the metallic fine particle-containing ink according to the present invention is preferably 3% by mass or more, more preferably 5% by mass or more, further preferably 10% by mass or more, still further preferably 15% by mass or more, still more further preferably 20% by mass or more, and even further preferably 25% by mass or more, and is preferably 60% by mass or less, more preferably 50% by mass or less, and further preferably 40% by mass or less, from the standpoint of the handleability of the ink, and the standpoint of the enhancement of the dispersion stability of the metallic fine particles, the reduction of the residual components in the metal film, the reduction of the hue change of the metal film, and the suppression of the occurrence of electrochemical migration.

### (Water)

The metallic fine particle-containing ink according to the present invention preferably further contains water from the standpoint of the handleability of the ink, and the standpoint of the enhancement of the dispersion stability of the metallic fine particles, the reduction of the residual components in the metal film, the reduction of the hue change of the metal film, and the suppression of the occurrence of electrochemical migration.

The content of water in the metallic fine particle-containing ink according to the present invention is preferably 5% by mass or more, more preferably 10% by mass or more, and further preferably 20% by mass or more, and is preferably 65% by mass or less, more preferably 50% by mass or less, further preferably 40% by mass or less, and still further preferably 35% by mass or less, from the same standpoints as above.

The metallic fine particle-containing ink according to the present invention may further contain various additives, such as a fixing aid, e.g., a dispersion of polymer particles, a moisturizing agent, a moistening agent, a penetrating agent, a surfactant, a viscosity modifier, an anti-foaming agent, an antiseptic, a fungicide, and a rust inhibitor, as an additional component other than the aforementioned components, in such a range that does not impair the effects of the present invention.

### (Method of producing Metallic Fine Particle-containing Ink)

The metallic fine particle-containing ink according to the present invention can be obtained by (i) a method of mixing a metal raw material compound, a reducing agent, and the polymer B as a dispersant, so as to reduce the metal raw material compound, (ii) a method of adding and mixing the polymer B as a dispersant, and depending on necessity the organic solvent C, water, and the like with the metallic fine particles A having been prepared in advance by the known method, and the like. Among these, (i) a method of mixing a metal raw material compound, a reducing agent, and the polymer B as a dispersant, so as to reduce the metal raw material compound is preferred from the standpoint of the enhancement of the dispersion stability of the metallic fine particles, the reduction of the residual components in the metal film, the reduction of the hue change of the metal film, and the suppression of the occurrence of electrochemical migration.

The method (i) is preferably a method in which metallic fine particle dried powder containing the polymer B is provided in advance, and then the organic solvent C and water as the ink solvent are added and mixed therewith.

The metallic fine particle dried powder can be obtained in such a manner that the metal raw material compound, the reducing agent, and the polymer B as a dispersant are mixed to reduce the metal raw material compound with the reducing agent, resulting in a dispersion of the metallic fine particles A dispersed with the polymer B, and then the dispersion of the metallic fine particles A is dried through freeze-drying or the like.

Examples of the metal raw material compound include a metal salt of an inorganic acid or an organic acid, a metal oxide, a metal hydroxide, a metal sulfide, and a metal halide, containing the metal exemplified for the metallic fine particles A above. Examples of the metal salt include a metal salt of an inorganic acid, such as a nitrate, a nitrite, a sulfate, a carbonate, an ammonium salt, and a perchlorate; and a metal salt of an organic acid, such as an acetate. One kind of the metal raw material compound may be used alone, or two or more kinds thereof may be used as a mixture. Among these, the metal raw material compound is preferably a metal salt of an inorganic acid or an organic acid, more preferably a metal salt of an inorganic acid, further preferably a metal salt of a nitric acid, and still further preferably silver nitrate, from the standpoint of the versatility and the productivity of the metallic fine particles.

The reducing agent is not particularly limited, and any of an inorganic reducing agent and an organic reducing agent may be used, and an organic reducing agent is preferred.

Examples of the organic reducing agent include an alcohol compound, such as ethylene glycol and propylene glycol; an aldehyde compound, such as formaldehyde, acetaldehyde, and propionaldehyde; an acid compound and a salt thereof, such as ascorbic acid and citric acid; an alkanolamine, such as ethanolamine, N-methylethanolamine, N,N-dimethylethanolamine (2-(dimethylamino)ethanol), N,N-diethylethanolamine, diethanolamine, N-methyldiethanolamine, triethanolamine, propanolamine, N,N-dimethylpropanolamine, butanolamine, and hexanolamine; an alkylamine, such as propylamine, butylamine, hexylamine, diethylamine, dipropylamine, dimethylethylamine, diethylmethylamine, and triethylamine; an aliphatic amine, such as a (poly)alkylenepolyamine, e.g., ethylenediamine, triethylenediamine, tetramethylethylenediamine, diethylenetriamine, dipropylenetriamine, triethylenetetramine, and tetraethylenepentamine; an alicyclic amine, such as piperidine, pyrrolidine, N-methylpyrrolidine, and morpholine; an aromatic amine, such as aniline, N-methylaniline, toluidine, anisidine, and phenetidine; and an aralkylamine, such as benzylamine and N-methylbenzylamine.

One kind of the reducing agent may be used alone, or two or more kinds thereof may be used in combination.

The temperature of the reduction reaction is preferably 5°C or more, more preferably 10°C or more, further preferably 20°C or more, and still further preferably 30°C or more, from the standpoint of the reduction and the uniformization of the particle diameter of the metallic fine particles, and is preferably 100°C or less, more preferably 80°C or less, and further preferably 50°C or less, from the standpoint of the stable production of the metallic fine particles.

The period of time of the reduction reaction may be appropriately regulated corresponding to the temperature of the reduction reaction, and for example, in the case where the temperature of the reduction reaction is 40°C, the period of time thereof is preferably 1 hour or more, more preferably 2 hours or more, and further preferably 3 hours or more, from the standpoint of the reduction and the uniformization of the particle diameter of the metallic fine particles, and is preferably 12 hours or less, more preferably 8 hours or less, and further preferably 6 hours or less, from the standpoint of the productivity. In the case where the temperature of the reduction reaction is 10°C, the period of time thereof is preferably 3 hours or more, more preferably 6 hours or more, and further preferably 12 hours or more, from the standpoint of the reduction and the uniformization of the particle diameter of the metallic fine particles, and is preferably 36 hours or less, more preferably 30 hours or less, and further preferably 26 hours or less, from the standpoint of the productivity.

The reduction reaction may be performed in an air atmosphere, or may be performed in an inert gas atmosphere, such as nitrogen gas.

In the method of producing the metallic fine particle-containing ink according to the present invention, the dispersion of metallic fine particles before freeze-drying may be purified from the standpoint of the removal of the impurities, such as the unreacted reducing agent and the excess polymer B that does not contribute to the dispersion of the metallic fine particles A.

The method of purifying the dispersion of metallic fine particles is not particularly limited, and examples thereof include a membrane treatment, such as dialysis and ultrafiltration; and a centrifugal treatment. Among these, a membrane treatment is preferred, and dialysis is more preferred, from the standpoint of the efficient removal of the impurities. The material of the dialysis membrane used for the dialysis is preferably regenerated cellulose.

The molecular weight cut-off of the dialysis membrane is preferably 1,000 or more, more preferably 5,000 or more, and further preferably 10,000 or more, and is preferably 100,000 or less, and more preferably 70,000 or less, from the standpoint of the efficient removal of the impurities.

The metallic fine particle-containing ink according to the present invention can be obtained by further adding the various additives described above depending on necessity, and then subjecting to a filtration treatment with a filter or the like.

The proportion of the reduced metal in the metal element contained in the metallic fine particle-containing ink according to the present invention (which may be hereinafter referred to as a "metal reduction rate") is preferably 80% by mass or more, more preferably 85% by mass or more, further preferably 90% by mass or more, still further preferably 95% by mass or more, and still more further preferably 97% by mass or more, and is preferably 100% by mass or less, and more preferably 100% by mass, from the standpoint of the reduction of the hue change of the metal film, and the suppression of the occurrence of electrochemical migration.

The metal reduction rate can be measured according to the method described in the examples.

The viscosity at 25°C of the metallic fine particle-containing ink according to the present invention is preferably 3 mPa -s or more, more preferably 5 mPa -s or more, further preferably 7 mPa s or more, still further preferably 9 mPa·s or more, and still more further preferably 9.5 mPa·s or more, and is preferably 15 mPa.s or less, more preferably 12 mPa·s or less, and further preferably 11 mPa·s or less, from the standpoint of the reduction of the hue change of the metal film, and the suppression of the occurrence of electrochemical migration.

The viscosity of the ink can be measured according to the method described in the examples with an E-type viscometer.

The pH at 20°C of the metallic fine particle-containing ink according to the present invention is preferably 7.0 or more, more preferably 7.2 or more, and further preferably 7.5 or more, from the standpoint of the storage stability. The pH thereof is preferably 11 or less, more preferably 10 or less, and further preferably 9.5 or less, from the standpoint of the resistance of components and the skin irritation. The pH of the ink can be measured according to the ordinary method.

### <Step of forming Metal Film>

The method of producing a composite material of the present invention includes a step of coating the metallic fine particle-containing ink on the substrate to form a metal film on the substrate.

### (Substrate)

Examples of the substrate according to the present invention include paper, a resin, and a composite material thereof.

Examples of the paper substrate include coated paper (such as coated paper and art paper), uncoated paper, plain paper, craft paper, synthetic paper, processed paper, and paper board.

Examples of the substrate formed of a resin include a synthetic resin film, such as polyethylene terephthalate (PET), polybutylene terephthalate (PBT), polyethylene (PE), polyamide (PA), polypropylene (PP), polyvinyl chloride (PVC), polymethyl methacrylate (PMMA), polystyrene (PS), an acrylonitrile-butadienestyrene copolymer (ABS), an acrylonitrile-styrene copolymer (AS), and polycarbonate (PC).

Among these, the substrate is preferably at least one kind selected from the group consisting of a paper substrate and a substrate formed of a resin, and more preferably a paper substrate, from the standpoint of the versatility and the environment.

As a material supporting the substrate (i.e., a supporting material), a cloth, a metal, glass, ceramics, and a composite material thereof may be used.

Examples of the cloth include a cloth formed of natural fibers, such as cotton, silk, and linen, or synthetic fibers, such as rayon fibers, acetate fibers, nylon fibers, and polyester fibers, and a mixed cloth formed of two or more kinds of these fibers.

Examples of the metal include gold, silver, copper, palladium, platinum, aluminum, nickel, and tin.

The present invention can form a favorable metal film even through the temperature of the sintering treatment is low, and therefore can provide a composite material including a metal film that suffers less hue change, and is suppressed in occurrence of electrochemical migration under a high temperature and high humidity condition, even in the case where the substrate used has a low heat resisting temperature. From this standpoint, the heat resisting temperature of the substrate according to the present invention is preferably 130°C or less, more preferably 110°C or less, further preferably 100°C or less, and still further preferably 90°C or less, and is preferably 50°C or more, more preferably 55°C or more, further preferably 60°C or more, and still further preferably 65°C or more. The heat resisting temperature of the substrate in the present invention means the upper limit temperature at which the properties of the substrate can be retained.

The thickness of the substrate according to the present invention is preferably 10 pm or more, more preferably 20 pm or more, and further preferably 30 pm or more, from the standpoint of the strength, and is preferably 500 pm or less, more preferably 400 pm or less, and further preferably 300 pm or less, from the standpoint of the economic efficiency.

### (Coating Step of Metallic Fine Particle-containing Ink)

In the present invention, preferred examples of the method of coating the metallic fine particle-containing ink on the substrate include various pattern printing methods, such as ink-jet printing, flexographic printing, gravure printing, screen printing, offset printing, and dispenser printing, and an ink-jet printing method is preferred from the standpoint that a pattern can be conveniently drawn without contact with the substrate.

The amount of the metallic fine particle-containing ink according to the present invention applied to the substrate may be appropriately regulated corresponding to the thickness of the metal film and the size and the kind of the circuit or the electrode to be formed.

In the present invention, in the case where the metallic fine particle-containing ink is coated on the substrate by ink-jet printing, the ink may be installed in a known ink-jet printer, and jetted as ink droplets onto the substrate to form a printed image and the like.

The ink-jet printer includes a thermal type and a piezo type, and the ink is more preferably applied to thermal type ink-jet printing.

The head temperature of the ink-jet head is preferably 15°C or more, more preferably 20°C or more, and further preferably 25°C or more, from the standpoint of the reduction of the resistivity of the metal film, and is preferably 45°C or less, more preferably 40°C or less, and further preferably 35°C or less, from the standpoint of the jettability.

The head voltage of the ink-jet head is preferably 5 V or more, more preferably 10 V or more, and further preferably 15 V or more, and is preferably 40 V or less, more preferably 35 V or less, and further preferably 30 V or less, from the standpoint of the efficiency in printing, and the like.

The driving frequency of the head is preferably 1 kHz or more, more preferably 5 kHz or more, and further preferably 10 kHz or more, and is preferably 50 kHz or less, more preferably 40 kHz or less, and further preferably 35 kHz or less, from the standpoint of the efficiency in printing, and the like.

The jetted droplet amount of the ink according to the present invention is preferably 5 pL or more, and more preferably 10 pL or more, and is preferably 30 pL or less, and more preferably 20 pL or less, all per one droplet.

The applied amount of the ink according to the present invention in terms of solid content onto the substrate is preferably 0.5 g/m² or more, more preferably 1 g/m² or more, and further preferably 2 g/m² or more, and is preferably 20 g/m² or less, more preferably 15 g/m² or less, and further preferably 10 g/m² or less.

The resolution in printing is preferably 200 dpi or more, and more preferably 300 dpi or more, and is preferably 1,000 dpi or less, more preferably 800 dpi or less, and further preferably 600 dpi or less. The "resolution" in the specification means the number of dots per one inch (2.54 cm) formed on the substrate. For example, "resolution of 600 dpi" means that ink droplets are jetted on a substrate with a line head having nozzle holes disposed in a number of 600 dpi (dot per inch) in terms per unit length of the nozzle line, providing a line of dots of 600 dpi per one inch corresponding thereto in the direction perpendicular to the conveying direction of the substrate, and ink droplets are jetted while conveying the substrate in the conveying direction, providing a line of dots of 600 dpi per one inch also in the conveying direction of the substrate. In the specification, the resolution in the direction perpendicular to the conveying direction of the substrate and the resolution in the conveying direction thereof are shown as the same value.

### (Sintering Step of Metallic Fine Particles)

The method of producing a composite material of the present invention preferably includes, after coating the metallic fine particle-containing ink on the substrate, a sintering step of sintering the metallic fine particles A in the ink film on the substrate from the standpoint of the reduction of the residual components in the metal film, the reduction of the hue change of the metal film, and the suppression of the occurrence of electrochemical migration.

The sintering step included evaporates and dries the medium in the ink film, and sinters the metallic fine particles A, and thereby forms a metal film containing a less amount of the residual components in the metal film.

The sintering treatment is preferably performed at less than the temperature at which the substrate is deformed, and specifically is performed preferably at 35°C or more, more preferably 50°C or more, further preferably 55°C or more, and still further preferably 60°C or more, from the standpoint of the reduction of the hue change of the metal film, and the suppression of the occurrence of electrochemical migration, and preferably 145°C or less, more preferably 130°C or less, further preferably 110°C or less, still further preferably 100°C or less, still more further preferably 98°C or less, even further preferably 95°C or less, even still further preferably 90°C or less, and even still more further preferably 80°C or less, from the same standpoint as above, all under ordinary pressure. The period of time of the sintering treatment may be appropriately selected depending on the heating temperature, and the period of time thereof is preferably 15 minutes or more, more preferably 30 minutes or more, and further preferably 45 minutes or more, and is preferably 180 minutes or less, more preferably 120 minutes or less, and further preferably 90 minutes or less.

In the present invention, as described above, a metal film having a less amount of the residual components in the metal film can be formed even though the sintering is performed at a low temperature, and therefore the sintering can be performed by heating at a temperature near the heat resisting temperature of the substrate even in the case where the substrate having a low heat resisting temperature is used. Accordingly, it is considered that the sintering at a temperature near the heat resisting temperature of the substrate can provide a composite material including the substrate and the metal film formed, which are further integrated through softening of the surface of the substrate, and the like, while suppressing the roughening of the surface of the metal film and the cracks inside the metal film in cooling, can reduce the hue change of the metal film, and can suppress the occurrence of electrochemical migration. From this standpoint, the temperature of the sintering treatment is, while depending on the material of the substrate, preferably (heat resisting temperature of substrate + 15°C) or less, more preferably (heat resisting temperature of substrate + 10°C) or less, further preferably (heat resisting temperature of substrate + 5°C) or less, and still further preferably the same temperature as the heat resisting temperature of the substrate.

The sintering treatment, preferably the sintering treatment by heating, may be performed under any pressure condition of the ordinary pressure (atmospheric pressure), an increased pressure, and a reduced pressure. The pressure in the sintering treatment is preferably 1 kPa or more, more preferably 5 kPa or more, further preferably 50 kPa or more, and still further preferably 90 kPa or more, from the standpoint of the reduction of the hue change of the metal film, and the suppression of the occurrence of electrochemical migration, and is preferably 150 MPa or less, more preferably 50 MPa or less, further preferably 1 MPa or less, still further preferably 200 kPa or less, and still more further preferably 150 kPa or less, from the same standpoint as above, and the sintering treatment is preferably performed under ordinary pressure (atmospheric pressure) from the standpoint of the productivity.

Examples of the method of heating include a method of heating by bringing a heater into contact with the surface of the substrate opposite to the surface having the ink film formed thereon, a method of storing the substrate having the ink film formed thereon in a thermostat chamber capable of retaining the temperature constant, a method of heating by applying hot air to the ink-coated surface on the substrate, a method of heating by bringing a heater close to the ink-coated surface on the substrate, a method of heating by steam aging with high temperature steam under ordinary pressure or high pressure, and a method of heating through irradiation of light, such as near infrared light or ultraviolet light.

The sintering step preferably further includes storing under a prescribed temperature and humidity environment, after heating, from the standpoint of the reduction of the hue change of the metal film, and the suppression of the occurrence of electrochemical migration. The storing is preferably performed at room temperature (preferably 10°C or more and 35°C or less).

The relative humidity of the surrounding environment for performing the storing is preferably 20% or more, more preferably 30% or more, and further preferably 40% or more, and is preferably 65% or less, and more preferably 60% or less, from the standpoint of the reduction of the hue change of the metal film, and the suppression of the occurrence of electrochemical migration.

The period of time of the storing is preferably 6 hours or more, more preferably 12 hours or more, and further preferably 24 hours or more, from the standpoint of the reduction of the hue change of the metal film, and the suppression of the occurrence of electrochemical migration, and is preferably 96 hours or less, more preferably 72 hours or less, and further preferably 60 hours or less, from the standpoint of the productivity.

The cross-sectional porosity of the metal film formed in the present invention is 30% by area or less, preferably 20% by area or less, more preferably 15% by area or less, further preferably 10% by area or less, still further preferably 7% by area or less, and still more further preferably 5% by area or less, and is 2% by area or more, preferably 3% by area or more, and more preferably 4% by area or more, from the standpoint of the reduction of the hue change of the metal film, and the suppression of the occurrence of electrochemical migration. The cross-sectional porosity of the metal film can be measured according to the method described in the examples.

The porosity can be regulated by the coating condition, such as the coating method of the metallic fine particle-containing ink and the thickness of the coating film, the sintering treatment condition, such as the heating temperature and the pressure, the kind and the metal reduction rate of the metallic fine particles, the kind and the amount of the dispersant, the production condition of the metallic fine particle-containing ink, such as the reduction temperature, and the like.

The content of the metal in the metal film formed in the present invention is preferably 90% by mass or more, more preferably 93% by mass or more, further preferably 95% by mass or more, still further preferably 97% by mass or more, and still more further preferably 98% by mass or more, and the upper limit thereof may be 100% by mass, from the standpoint of the reduction of the hue change of the metal film, and the suppression of the occurrence of electrochemical migration. The content of the metal in the metal film can be measured according to the method described in the examples.

The amount of the metal in the metal film can be regulated by the coating condition, such as the coating method of the metallic fine particle-containing ink and the thickness of the coating film, the sintering treatment condition, such as the heating temperature and the pressure, the kind and the metal reduction rate of the metallic fine particles, the kind and the amount of the dispersant, the production condition of the metallic fine particle-containing ink, such as the reduction temperature, and the like.

The thickness of the metal film formed in the present invention is preferably 0.05 pm or more, more preferably 0.1 pm or more, further preferably 0.2 pm or more, still further preferably 0.4 pm or more, still more further preferably 0.6 pm or more, and even further preferably 0.8 pm or more, and is preferably 60 pm or less, more preferably 50 pm or less, further preferably 30 pm or less, still further preferably 10 pm or less, still more further preferably 7 pm or less, even further preferably 5 pm or less, even still further preferably 3 pm or less, and even still more further preferably 2 pm or less, from the standpoint of the reduction of the hue change of the metal film, and the suppression of the occurrence of electrochemical migration. The thickness of the metal film can be measured according to the method described in the examples.

The thickness of the metal film can be regulated by the coating condition, such as the coating method of the metallic fine particle-containing ink and the thickness of the coating film, the sintering treatment condition, such as the heating temperature and the pressure, the kind and the metal reduction rate of the metallic fine particles, the kind and the amount of the dispersant, the production condition of the metallic fine particle-containing ink, such as the reduction temperature, and the like. The thickness of the metal film can be regulated particularly by the coating condition, such as the coating method and the thickness of the coating film, and the sintering treatment condition, such as the heating temperature and the pressure.

The composite material obtained by the production method of the present invention includes a substrate and a metal film formed on the substrate, in which the metal film suffers less hue change, and is suppressed in occurrence of electrochemical migration, and therefore the composite material can be used as a conductive composite material for various electric and electronic equipments. From this standpoint, the composite material obtained by the production method of the present invention is preferably used in various devices, for example, a tag for an automatic recognition system using near field communication (RFID (radio frequency identifier), a capacitor, such as MLCC (multilayer ceramic capacitor); electronic paper; an image display device, such as a liquid crystal display, an organic EL display, and a touch-sensitive panel; an organic EL device; an organic transistor; a circuit board, such as a printed circuit board and a flexible circuit board; an organic solar cell; a flexible battery; and a sensor, such as a flexible sensor.

In relation to the aforementioned embodiments, the present invention further describes the following embodiments.
<1> A method of producing a composite material including a substrate and a metal film formed on the substrate, including
   a step of coating a metallic fine particle-containing ink on the substrate to form a metal film on the substrate,
   the substrate having a heat resisting temperature of 130°C or less,
   the metallic fine particle-containing ink containing metallic fine particles A dispersed with a polymer B, the metallic fine particles A having a volume average particle diameter D_{A} of 10 nm or more and 60 nm or less,
   the metal film having a cross-sectional porosity of 2% by area or more and 30% by area or less, and
   the metal film having a content of a metal of 90% by mass or more.
<2> The method of producing a composite material including a substrate and a metal film formed on the substrate described in the item <1>, including
   a step of coating a metallic fine particle-containing ink on the substrate to form a metal film on the substrate,
   the substrate having a heat resisting temperature of 130°C or less,
   the metallic fine particle-containing ink containing metallic fine particles A dispersed with a polymer B, the metallic fine particles A having a volume average particle diameter D_{A} of 10 nm or more and 60 nm or less,
   a metal constituting the metallic fine particles A containing at least one kind selected from the group consisting of gold, silver, copper, nickel, and palladium,
   the metallic fine particle-containing ink having a mass ratio ((polymer B)/((metallic fine particles A)+(polymer B))) of the content of the polymer B with respect to the total content of the metallic fine particles A and the polymer B of 0.01 or more and 0.2 or less,
   the polymer B being a vinyl-based polymer containing a constitutional unit derived from a monomer (b-1) having a carboxy group and a constitutional unit derived from a monomer (b-2) having a polyoxyalkylene group,
   the metallic fine particle-containing ink having a content of the metallic fine particles A of 2% by mass or more and 85% by mass or less,
   the metal film having a cross-sectional porosity of 2% by area or more and 30% by area or less, and
   the metal film having a content of a metal of 90% by mass or more.
<3> The method of producing a composite material including a substrate and a metal film formed on the substrate described in the item <1> or <2>, including
   a step of coating a metallic fine particle-containing ink on the substrate to form a metal film on the substrate,
   the substrate having a heat resisting temperature of 130°C or less,
   the substrate being at least one kind selected from the group consisting of a paper substrate and a substrate formed of a resin,
   the metallic fine particle-containing ink containing metallic fine particles A dispersed with a polymer B, the metallic fine particles A having a volume average particle diameter D_{A} of 10 nm or more and 60 nm or less,
   a metal constituting the metallic fine particles A containing at least one kind selected from the group consisting of gold, silver, copper, nickel, and palladium,
   the metallic fine particle-containing ink having a mass ratio ((polymer B)/((metallic fine particles A)+(polymer B))) of the content of the polymer B with respect to the total content of the metallic fine particles A and the polymer B of 0.01 or more and 0.2 or less,
   the polymer B being a vinyl-based polymer containing a constitutional unit derived from a monomer (b-1) having a carboxy group and a constitutional unit derived from a monomer (b-2) having a polyoxyalkylene group,
   the metallic fine particle-containing ink having a content of the metallic fine particles A of 2% by mass or more and 85% by mass or less,
   the metallic fine particle-containing ink containing at least one kind selected from the group consisting of a diol and a triol as an organic solvent C,
   the metal film having a cross-sectional porosity of 2% by area or more and 30% by area or less,
   the metal film having a content of a metal of 90% by mass or more, and
   the metal film having a thickness of 0.05 pm or more and 60 pm or less.
<4> The method of producing a composite material including a substrate and a metal film formed on the substrate described in any one of the items <1> to <3>, including
   a step of coating a metallic fine particle-containing ink on the substrate, and then sintering the metallic fine particles A in an ink film on the substrate, so as to form a metal film on the substrate,
   the substrate having a heat resisting temperature of 130°C or less,
   the substrate being at least one kind selected from the group consisting of a paper substrate and a substrate formed of a resin,
   the metallic fine particle-containing ink containing metallic fine particles A dispersed with a polymer B, the metallic fine particles A having a volume average particle diameter D_{A} of 10 nm or more and 60 nm or less,
   a metal constituting the metallic fine particles A containing at least one kind selected from the group consisting of gold, silver, copper, nickel, and palladium,
   the metallic fine particle-containing ink having a mass ratio ((polymer B)/((metallic fine particles A)+(polymer B))) of the content of the polymer B with respect to the total content of the metallic fine particles A and the polymer B of 0.01 or more and 0.2 or less,
   the polymer B being a vinyl-based polymer containing a constitutional unit derived from a monomer (b-1) having a carboxy group and a constitutional unit derived from a monomer (b-2) having a polyoxyalkylene group,
   the metallic fine particle-containing ink having a content of the metallic fine particles A of 2% by mass or more and 85% by mass or less,
   the metallic fine particle-containing ink containing at least one kind selected from the group consisting of a diol and a triol as an organic solvent C,
   the sintering treatment temperature being the heat resisting temperature of the substrate + 15°C or less,
   the sintering treatment pressure being 1 kPa or more and 150 MPa or less,
   the metal film having a cross-sectional porosity of 2% by area or more and 30% by area or less,
   the metal film having a content of a metal of 90% by mass or more, and
   the metal film having a thickness of 0.05 pm or more and 60 pm or less.
<5> The method of producing a composite material described in the item <4>, wherein the sintering treatment temperature is 60°C or more and 98°C or less.
<6> The method of producing a composite material described in the item <4> or <5>, wherein the sintering treatment time is 15 minutes or more and 180 minutes or less.
<7> The method of producing a composite material described in any one of the items <3> to <6>, wherein the organic solvent C contains at least one kind selected from the group consisting of a 1,2-alkanediol, an α,ω-alkanediol, and glycerin.
<8> The method of producing a composite material described in any one of the items <3> to <7>, wherein the organic solvent C contains at least one kind selected from the group consisting of ethylene glycol, propylene glycol, 1,4-butanediol, and glycerin.
<9> The method of producing a composite material described in any one of the items <1> to <8>, wherein a metal element contained in the metallic fine particle-containing ink has a proportion of a reduced metal of 80% by mass or more.
<10> The method of producing a composite material described in any one of the items <1> to <9>, wherein the metallic fine particle-containing ink has a viscosity at 25°C of 3 mPa·s or more and 15 mPa·s or less.
<11> The method of producing a composite material described in any one of the items <1> to <10>, wherein the metallic fine particle-containing ink is coated on the substrate by an ink-jet printing method.
<12> A device including a composite material produced by the production method described in any one of the items <1> to <11>.

### Examples

In Synthesis Examples, Examples, and Comparative Examples below, "part" and "%" mean "part by mass" and "% by mass", respectively, unless otherwise indicated.

The properties were measured or calculated by the following methods.

### [Number Average Molecular Weight Mn of Polymer B]

The number average molecular weight was measured by gel permeation chromatography (GPC apparatus: HLC-8320GPC, available from Tosoh Corporation; columns: TSKgel Super AWM-H, TSKgel Super AW3000, and TSKgel guardcolumn Super AW-H, all available from Tosoh Corporation; flow rate: 0.5 mL/min) using a solution prepared by dissolving phosphoric acid and lithium bromide in N,N-dimethylformamide to make concentrations thereof of 60 mmol/L and 50 mmol/L, respectively, as an eluent, and using the monodisperse polystyrene kit having known molecular weights (PStQuick B (F-550, F-80, F-10, F-1, A-1000), PStQuick C (F-288, F-40, F-4, A-5000, A-500), all available from Tosoh Corporation, as the standard substance.

The measurement specimen used was prepared by mixing 0.1 g of the polymer B with 10 mL of the eluent in a glass vial, stirring the resulting mixture at 25°C for 10 hours with a magnetic stirrer, and then filtering the mixture through a syringe filter (DISMIC-13HP, PTFE; 0.2 µm, available from Advantec Co., Ltd.).

### [Content of Metallic Fine Particles A and Content of Polymer B in Metallic Fine Particle Dispersion or Metallic Fine Particle-containing Ink]

With a simultaneous thermogravimetry/differential thermal analyzer (TG/DTA) "STA7200RV" (available from Hitachi High-Tech Science Corporation), 10 mg of the specimen was weighed on an aluminum pan, and heated from 35°C to 550°C at a temperature rise rate of 10°C/min, and the mass decrease under a nitrogen flow of 50 mL/min was measured. The content of the metallic fine particles A and the content of the polymer B in the metallic fine particle dispersion or the metallic fine particle-containing ink were calculated under assumption that the mass decrease from 35°C to 200°C was the mass of the solvent, the mass decrease from 200°C to 550°C was the mass of the polymer B, and the remaining mass at 550°C was the mass of the metallic fine particles A.

### [Volume Average Particle Diameter D_{A} of Metallic Fine Particles A]

The metallic fine particle-containing ink was diluted with ion exchanged water to make a content of the metal of 0.1% by mass. The diluted ink was coated on a hydrophilized carbon support film "Elastic Carbon Film ELS-C10" (available from Okenshoji Co., Ltd.), and after spontaneously drying, an STEM image thereof was obtained with a field emission scanning electron microscope (FE-SEM) (Model: S-4800, available from Hitachi High-Tech Corporation) in the STEM mode under condition of an acceleration voltage of 30 kV. The STEM image obtained was processed with an image analyzing software "A-Zou Kun" (available from Asahi Kasei Engineering Corporation), and the volume average particle diameter D_{A} was calculated.

### [Proportion of Reduced Metal in Metal Element contained in Metallic Fine Particle-containing Ink (Metal Reduction Rate)]

### (Case where Metal constituting Metallic Fine Particles A is Silver)

Silver oxide (guaranteed reagent, available from Fujifilm Wako Pure Chemical Corporation) and silver powder (purity: 99.9% or more, available from Kojima Chemicals Co., Ltd.) were weighed to make mass ratios ((silver oxide)/(silver powder)) of 1/9, 8/2, 7/3, 5/5, 3/7, 2/8, and 9/1, and well mixed to prepare specimens. The specimens each were placed on a glass holder and measured with a powder-thin film X-ray diffractometer "Desktop X-ray Diffractometer MiniFlex" (available from Rigaku Corporation) at a rate of 10°/min in a range of 5° to 90°. A calibration curve of the mass ratio ((silver oxide)/(silver)) and the integrated intensity was prepared from the integrated intensity ratio of the peak derived from silver oxide (55.0°) and the peak derived from silver (77.5°).

Separately, the metallic fine particle-containing ink was freeze-dried with a freeze-dryer (Model: FDU-2110, available from Tokyo Rikakikai Co., Ltd.) equipped with a dry chamber (Model: DRC-1000, available from Tokyo Rikakikai Co., Ltd.) under drying condition (freezing at -25°C for 1 hour, decompressing at - 10°C for 9 hour, and decompressing at 25°C for 5 hours, decompression degree: 5 Pa), so as to provide metallic fine particle dried powder. The resulting metallic fine particle dried powder was placed on a glass holder and measured with a powder-thin film X-ray diffractometer "Desktop X-ray Diffractometer MiniFlex" (available from Rigaku Corporation) at a rate of 10°/min in a range of 5° to 90°. The metal reduction rate was obtained from the calibration curve.

### (Case where Metal constituting Metallic Fine Particles A is Nickel)

A calibration curve was prepared in the same manner as the case of silver above except that nickel oxide (guaranteed reagent, NiO, available from Fujifilm Wako Pure Chemical Corporation) and nickel powder (2 to 3 pm powder, NIE02PB, available from Kojundo Chemical Lab. Co., Ltd.) were used. The calibration curve was prepared by using the peak derived from nickel oxide (37.3°) and the peak derived from nickel (51.9°). The metal reduction rate was obtained in the same manner as the case of silver except the above.

### [Viscosity of Metallic Fine Particle-containing Ink]

The viscosity at 25°C of the ink was measured with an E-type viscometer (available from Toki Sangyo Co., Ltd., Model No.: TV-25, Standard Cone Rotor 1° 34' × R24, rotation number: 50 rpm).

### Synthesis Example 1 (Synthesis of Polymer B1)

100 g of 1,4-dioxane was placed in a 1,000 mL four-neck round-bottom flask equipped with a thermometer, two dropping funnels having a 100 mL nitrogen bypass, and a reflux device, and after increasing the inner temperature of the flask to 90°C on an oil bath, nitrogen was bubbled therein for 10 minutes. Subsequently, 3 g of 98% acrylic acid (guaranteed reagent, available from Fujifilm Wako Pure Chemical Corporation), 37 g of methoxypolyethylene glycol (EO 9 mol) acrylate ("NK Ester AM-90G, available from Shin-Nakamura Chemical Co., Ltd.), 60 g of styrene (guaranteed reagent, available from Fujifilm Wako Pure Chemical Corporation), and 1.5 g of 3-mercaptopropionic acid (guaranteed reagent, available from Fujifilm Wako Pure Chemical Corporation) were dissolved in a resin beaker, and placed in the dropping funnel (1). Separately, 20 g of 1,4-dioxane and 0.15 g of 2,2'-azobis(2,4-dimethylvaleronitrile) ("V-65", polymerization initiator, available from Fujifilm Wako Pure Chemical Corporation) were dissolved in a resin beaker, and placed in the dropping funnel (2). Subsequently, the mixtures in the dropping funnel (1) and the dropping funnel (2) were simultaneously dropped into the flask over 90 minutes. Thereafter, after increasing the temperature inside the flask to 90°C, the mixture was further agitated for 1 hour. Thereafter, the mixture was cooled to room temperature, and then distilled until the distilled matter was completed with a rotary distillation apparatus "Rotary Evaporator N-1000S" (available from Tokyo Rikakikai Co., Ltd.) at a rotation number of 50 rpm, a bath temperature of 80°C, and a pressure of 100 torr. Thereafter, the residue was dried with a vacuum dryer "VO-420" (available from Advantec Toyo Kaisha, Ltd.) at a temperature of 110°C and a pressure of 40 torr for 48 hours, so as to provide a polymer B1 (acrylic acid-methoxypolyethylene glycol (EO 9 mol) acrylate-styrene copolymer, acid value: 23 mgKOH/g, Mn: 10,300).

### Production Example 1 (Production of Metallic Fine Particle-containing Ink I-1)

### [Production of Metallic Fine Particle Dried Powder 1]

### (Step 1)

23 g of N,N-dimethylethanolamine (hereinafter referred to as "DMEA") as a reducing agent was placed in a 1,000 mL glass beaker, and heated to 40°C on an oil bath under agitation with a magnetic stirrer.

Separately, 140 g of silver nitrate as a metal raw material compound, 8 g of the polymer B1 as a dispersant, and 70 g of ion exchanged water were placed in a 100 mL beaker, and agitated at 40°C with a magnetic stirrer until becoming visually transparent, so as to provide a mixed liquid.

Subsequently, the resulting mixed liquid was placed in a 1,000 mL dropping funnel, and the mixed liquid was dropped into DMEA retained to 40°C over 30 minutes. Thereafter, the reaction liquid was agitated for 5 hours while regulating the temperature of the reaction liquid to 40°C on an oil bath, and then air-cooled to provide a dark brown dispersion containing dispersed silver fine particles.

### (Step 2)

The entire amount of the dispersion obtained in the step 1 was placed in a dialysis tube ("Spectra Por 6", available from Repligen Corporation, dialysis membrane: regenerated cellulose, molecular weight cut-off (MWCO): 50 K), and the ends of the tube were sealed with closers. The tube was immersed in 5 L of ion exchanged water in a 5 L glass beaker, which was agitated for 1 hour while retaining the temperature of water to 20 to 25°C. Thereafter, an operation of replacing the entire amount of ion exchanged water every 1 hour was repeated three times, and then specimens were sampled every 1 hour. The dialysis was terminated at the time when the mass ratio ((polymer B)/((metallic fine particles A)+(Polymer B))) calculated from the masses of the metallic fine particles A and the polymer B measured by the method using a simultaneous thermogravimetry/differential thermal analyzer (TG/DTA) above became 1.9/41.9, so as to provide a purified dispersion.

### (Step 3)

The purified dispersion obtained in the step 2 was freeze-dried with a freeze-dryer (Model No.: FDU-2110, available from Tokyo Rikakikai Co., Ltd.) equipped with a dry chamber (Model No.: DRC-1000, available from Tokyo Rikakikai Co., Ltd.) under drying condition (freezing at -25°C for 1 hour, decompressing at -10°C for 9 hour, and decompressing at 25°C for 5 hours, decompression degree: 5 Pa), so as to provide metal fine particle dried powder 1.

### [Production of Metallic Fine Particle-containing Ink]

419 g of the metallic fine particle dried powder 1, 300 g of propylene glycol, 280 g of ion exchanged water, and 1 g of an acetylene glycol-based surfactant ("Surfynol 104PG-50, available from Nisshin Chemical Co., Ltd., a propylene glycol solution of 2,4,7,9-tetramethyl-5-decyn-4,7-diol, active ingredient: 50%) were placed in a 5,000 mL polyethylene beaker, and dispersed with an ultrasonic dispersion device (Model: US-3001, available from Nissei Corporation) under agitation with a magnetic stirrer for 3 hours. Thereafter, the mixture was filtered with a 5 pm disposal membrane filter (Minisart, available from Sartorius AG), so as to provide a metallic fine particle-containing ink I-1.

### Production Example 2 (Production of Metallic Fine Particle-containing Ink I-2)

A metallic fine particle-containing ink I-2 was obtained in such a manner that the metallic fine particle-containing ink 1-1 obtained in Production Example 1 was further bubbled with oxygen gas fed at a rate of 100 mL/min at 25°C for 2 hours, so as to oxidize silver partially.

### Production Example 3 (Production of Metallic Fine Particle-containing Ink I-3)

23 g of N,N-dimethylethanolamine (DMEA) as a reducing agent was placed in a 1,000 mL glass beaker, and cooled to 10°C on an ice bath under agitation with a magnetic stirrer.

Separately, 140 g of silver nitrate as a metal raw material compound, 2.6 g of the polymer B 1 as a dispersant, and 70 g of ion exchanged water were placed in a 100 mL beaker, and agitated at 10°C with a magnetic stirrer until becoming visually transparent, so as to provide a mixed liquid.

Subsequently, the resulting mixed liquid was placed in a 1,000 mL dropping funnel, and the mixed liquid was dropped into DMEA retained to 10°C over 30 minutes. Thereafter, the reaction liquid was agitated for 24 hours while regulating the temperature of the reaction liquid to 10°C on an oil bath, and then returned to room temperature to provide a dark brown dispersion containing dispersed silver fine particles. Subsequently, metallic fine particle dried powder 2 was obtained by using the entire amount of the resulting dispersion in the same manner as in the steps 2 and 3 of Production Example 1, and then a metallic fine particle-containing ink I-3 was obtained by using the metallic fine particle dried powder 2 in the same manner as in Production of Metallic Fine Particle-containing Ink of Production Example 1.

### Production Example 4 (Production of Metallic Fine Particle-containing Ink I-4)

23 g of N,N-dimethylethanolamine (DMEA) as a reducing agent was placed in a 1,000 mL glass beaker, and cooled to 10°C on an ice bath under agitation with a magnetic stirrer.

Separately, 140 g of silver nitrate, 16 g of the polymer B1 as a dispersant, and 70 g of ion exchanged water were placed in a 100 mL beaker, and agitated at 10°C with a magnetic stirrer until becoming visually transparent, so as to provide a mixed liquid.

Subsequently, the resulting mixed liquid was placed in a 1,000 mL dropping funnel, and the mixed liquid was dropped into DMEA retained to 10°C over 30 minutes. Thereafter, the reaction liquid was agitated for 24 hours while regulating the temperature of the reaction liquid to 10°C on an oil bath, and then returned to room temperature to provide a dark brown dispersion containing dispersed silver fine particles. Subsequently, metallic fine particle dried powder 3 was obtained by using the entire amount of the resulting dispersion in the same manner as in the steps 2 and 3 of Production Example 1, and then a metallic fine particle-containing ink I-4 was obtained by using the metallic fine particle dried powder 3 in the same manner as in Production of Metallic Fine Particle-containing Ink of Production Example 1.

### Production Example 5 (Production of Metallic Fine Particle-containing Ink I-5)

23 g of N,N-dimethylethanolamine (DMEA) as a reducing agent was placed in a 1,000 mL glass beaker, and cooled to 10°C on an ice bath under agitation with a magnetic stirrer.

Separately, 272 g of nickel acetate (guaranteed reagent, available from Fujifilm Wako Pure Chemical Corporation) as a metal raw material compound, 8 g of the polymer B1 as a dispersant, and 200 g of ion exchanged water were placed in a 100 mL beaker, and agitated at 10°C with a magnetic stirrer until becoming visually transparent, so as to provide a mixed liquid.

Subsequently, the resulting mixed liquid was placed in a 1,000 mL dropping funnel, and the mixed liquid was dropped into DMEA retained to 10°C over 30 minutes. Thereafter, the reaction liquid was agitated for 24 hours while regulating the temperature of the reaction liquid to 10°C on an oil bath, and then returned to room temperature to provide a dark brown dispersion containing dispersed silver fine particles. Subsequently, metallic fine particle dried powder 4 was obtained by using the entire amount of the resulting dispersion in the same manner as in the steps 2 and 3 of Production Example 1, and then a metallic fine particle-containing ink I-5 was obtained by using the metallic fine particle dried powder 4 in the same manner as in Production of Metallic Fine Particle-containing Ink of Production Example 1.

### Production Example 6 (Production of Metallic Fine Particle-containing Ink I-6)

A metallic fine particle-containing ink I-6 was obtained in such a manner that the metallic fine particle-containing ink 1-1 obtained in Production Example 1 was further bubbled with compressed air fed at a rate of 100 mL/min at 25°C for 2 hours, so as to oxidize silver partially.

### Comparative Production Example 1 (Metallic Fine Particle-containing Ink I-C1)

Metallic fine particle dried powder C1 was obtained in the same manner as in Production Example 1 except that tannic acid (chemical grade, available from Hayashi Pure Chemical Ind., Ltd.) was used instead of the polymer B1 as the dispersant, and then a metallic fine particle-containing ink I-C1 was obtained by using the metallic fine particle dried powder C1 in the same manner as in Production of Metallic Fine Particle-containing Ink of Production Example 1.

### Comparative Production Example 2 (Metallic Fine Particle-containing Ink I-C2)

23 g of N,N-dimethylethanolamine (DMEA) as a reducing agent was placed in a 1,000 mL glass beaker, and heated to 80°C on an oil bath under agitation with a magnetic stirrer.

Separately, 140 g of silver nitrate, 16 g of the polymer B1 as a dispersant, and 70 g of ion exchanged water were placed in a 100 mL beaker, and agitated at 80°C with a magnetic stirrer until becoming visually transparent, so as to provide a mixed liquid.

Subsequently, the resulting mixed liquid was placed in a 1,000 mL dropping funnel, and the mixed liquid was dropped into DMEA retained to 80°C over 30 minutes. Thereafter, the reaction liquid was agitated for 5 hours while regulating the temperature of the reaction liquid to 80°C on an oil bath, and then air-cooled to provide a dark brown dispersion containing dispersed silver fine particles. Subsequently, metallic fine particle dried powder C2 was obtained by using the entire amount of the resulting dispersion in the same manner as in the steps 2 and 3 of Production Example 1, and then a metallic fine particle-containing ink I-C2 was obtained by using the metallic fine particle dried powder C2 in the same manner as in Production of Metallic Fine Particle-containing Ink of Production Example 1.

### Comparative Production Example 3 (Metallic Fine Particle-containing Ink I-C3)

23 g of N,N-dimethylethanolamine (DMAE) as a reducing agent was placed in a 1,000 mL glass beaker, and cooled to 10°C on an ice bath under agitation with a magnetic stirrer.

Separately, 140 g of silver nitrate, 2 g of the polymer B1 as a dispersant, and 70 g of ion exchanged water were placed in a 100 mL beaker, and agitated at 10°C with a magnetic stirrer until becoming visually transparent, so as to provide a mixed liquid.

Subsequently, the resulting mixed liquid was placed in a 1,000 mL dropping funnel, and the mixed liquid was dropped into DMAE retained to 10°C over 30 minutes. Thereafter, the reaction liquid was agitated for 24 hours while regulating the temperature of the reaction liquid to 10°C on an oil bath, and then returned to room temperature to provide a dark brown dispersion containing dispersed silver fine particles. Subsequently, metallic fine particle dried powder C3 was obtained by using the entire amount of the resulting dispersion in the same manner as in the steps 2 and 3 of Production Example 1, and then a metallic fine particle-containing ink I-C3 was obtained by using the metallic fine particle dried powder C3 in the same manner as in Production of Metallic Fine Particle-containing Ink of Production Example 1.

### Examples 1, 6 to 9, and 13 and Comparative Examples 1 to 3

### (Production of Evaluation Composite Material (1))

### [Coating Step of Metallic Fine Particle-containing Ink]

By using the metallic fine particle-containing inks shown in Table 1, the ink in the black cartridge of the ink-jet printer (Model No.: Deskjet 6122, available from HP, Inc., thermal type) was replaced with each of the metallic fine particle-containing inks in an environment of a temperature of 25±1°C and a relative humidity of 30±5%. Subsequently, the cleaning operation was performed once from the utility menu of the printer. After all the nozzles of the black head were able to jet the ink with no problem, a recoating operation was performed in such a manner that a solid image of 204 mm in width and 275 mm in length formed with Photoshop (registered trademark) with RGB of 0,0,0 was printed with the ink-jet printer 5 times on a commercially available paper base board (Photo Paper "GL-101A450", heat resisting temperature: 70°C, thickness: 270 pm, A4-size, available from Canon Inc.) as the substrate, so as to provide a printed matter including the paper base board having an ink film formed thereon (printing condition: kind of paper: photo gloss paper, mode: fine, gray scale).

### [Sintering Step of Metallic Fine Particles]

Subsequently, the resulting printed matter was heated on a hot stage at 70°C for 60 minutes, and then subjected to a sintering treatment by storing at a temperature of 25°C and a humidity of 55% for 48 hours, so as to provide a composite material including the paper base board having a metal film formed thereon. The resulting composite material was subjected to the following evaluation of the hue change of the metal film.

### (Production of Evaluation Composite Material (2))

A composite material including a comb-shaped electrode having an electrode length of 20 mm, an electrode thickness of 0.8 pm, and an L&S (line and space) of 200 × 200 pm was obtained in the same manner as in the production of the evaluation composite material (1) above except that an L&S pattern was used instead of the solid image. The resulting composite material was subjected to the following evaluation of the electrochemical migration.

### Example 2

A composite material was obtained in the same manner as in Example 1 except that in the coating step of Example 1, the recoating operation was not performed, but the solid image was printed once.

### Example 3

A composite material was obtained in the same manner as in Example 1 except that in the coating step of Example 1, the number of printing in the recoating operation was changed from 5 times to 250 times.

### Example 4

A composite material was obtained in the same manner as in Example 1 except that in the sintering step of Example 1, the resulting printed matter was heated and pressurized under condition of 70°C and 150 MPa with a compact heat press machine (Model No.: H300, available from AS ONE Corporation).

### Example 5

A composite material was obtained in the same manner as in Example 1 except that in the sintering step of Example 1, the resulting printed matter was heated and depressurized under condition of 70°C and 8 kPa with a reduced pressure dryer (Model: ADP300, available from Yamato Scientific Co., Ltd.).

### Example 10

A composite material was obtained in the same manner as in Example 1 except that in the sintering step of Example 1, the heating temperature was changed from 70°C to 80°C.

### Example 11

A composite material was obtained in the same manner as in Example 1 except that in the sintering step of Example 1, the heating temperature was changed from 70°C to 95°C.

### Example 12

A composite material was obtained in the same manner as in Example 1 except that in the coating step of Example 1, a 1% by mass aqueous solution of the polymer B 1 was coated once on the surface of the ink film of the resulting printed matter with a bar coater (wire No. 4, available from Dai-ichi Rika Co., Ltd.).

### Comparative Example 4

A composite material was obtained in the same manner as in Example 1 except that in the sintering step of Example 1, the heating temperature was changed from 70°C to 100°C.

### Comparative Example 5

A composite material was obtained in the same manner as in Example 1 except that in the sintering step of Example 1, the printed matter was not heated but was stored at a temperature of 4°C and a humidity of 55% for 48 hours.

### [Measurement of Cross-sectional Porosity of Metal Film and Content of Metal in Metal Film]

The evaluation composite material (1) obtained in each of Examples and Comparative Examples was sputtered with Pt for 3 minutes, and then mounted on a cooling ion milling equipment (IB-19520CCP, available from JEOL, Ltd.). A cross section was formed under condition of an acceleration voltage of 4 kV and an electric current of 80 pA at -10°C. The resulting cross section was subjected to SEM observation and EDS (elemental) analysis with a scanning electron microscope (SEM) (Model: JSM-IT500HR, available from JEOL, Ltd.) under condition of an acceleration voltage of 7.0 kV. The resulting observation image was processed with an image analyzing software "A-Zou Kun" (available from Asahi Kasei Engineering Corporation), and the cross-sectional porosity (% by area) of the metal film and the content of the metal in the metal film were calculated. The results are shown in Table 2.

### (Measurement of Thickness of Metal Film)

The printed matter obtained in each of Examples and Comparative Examples was processed with a cross section polisher "IB-19520CCP" (available from JEOL, Ltd.), so as to provide a test piece having a flat cross sectional surface.

Subsequently, the test piece was attached to an SEM stage (Type T, available from Nisshin EM Co., Ltd.) with a double-sided adhesive carbon tape with an aluminum substrate for SEM (catalog No. 732, available from Nisshin EM Co., Ltd.), and the cross sectional surface was observed with a field emission scanning electron microscope "FE-SEM" (available from Hitachi High-Tech Corporation, Model: S-4800) in the SEM mode under condition of an acceleration voltage of 10 kV, so as to provide a secondary electron image. The thickness of the metal film was measured at 10 points on the metal film in the secondary electron image, and the thickness of the metal film was obtained by arithmetic average. The results are shown in Table 2.

### <Evaluation>

### (Evaluation of Hue Change of Metal Film)

The evaluation composite material (1) obtained in each of Examples and Comparative Examples was measured for the L* value before storing in the SCI mode (including specular light) with an integrating sphere spectrocolorimeter (Model: CM-700d, available from Konica Minolta, Inc.). An L* value closer to 100 means that the whiteness degree inherent to metal is better exhibited.

Subsequently, the composite material was stored under condition of a temperature of 60°C and a humidity of 80% for one week, and then measured for the L* value after storing in the same manner as in the measurement of the L* value before storing, and the change rate of the L* value before and after storing (= (L* value after storing)/(L* value before storing) × 100) was calculated and designated as an index of the change rate of the whiteness degree of the metal film. A change rate of the L* value before and after storing closer to 100% means that the hue change of the metal film is smaller. The results are shown in Table 2.

### [Evaluation of Electrochemical Migration]

The evaluation composite material (2) obtained in each of Examples and Comparative Examples was held in the state where a voltage of 5 V was applied to both ends of the comb-shaped electrode formed therein under an atmosphere of a temperature of 80°C and a humidity of 85%, and the time (t) until the electric current value reached 0.1 mA was measured. A longer time (t) means that the occurrence of electrochemical migration is better suppressed. The results are shown in Table 2.

**Table 1**

| | | Metallic fine particle-containing ink | | | | | | | | | | | | |
|---|---|---|---|---|---|---|---|---|---|---|---|---|---|---|
| | | Kind | Kind of metallic fine particle dried powder | Metallic fine particles A | | Kind of dispersant | Composition of ink (% by mass) | | | | | Mass ratio (B/(A+B)) *3 | Metal reduction rate (% by mass) | Ink viscosity (25°C) (mPa ·s) |
| | | | | Kind of metal | Volume average particle diameter D_{A} (nm) | | Metallic fine particles A | Polymer B | PG *1 | Ion exchanged water | Surfactant *2 | | | |
| Example | 1 | I-1 | 1 | silver | 33 | Polymer B1 | 40.0 | 1.9 | 30.05 | 28.0 | 0.05 | 0.045 | 100 | 10.2 |
| | 2 | I-1 | 1 | silver | 33 | Polymer B1 | 40.0 | 1.9 | 30.05 | 28.0 | 0.05 | 0.045 | 100 | 10.2 |
| | 3 | I-1 | 1 | silver | 33 | Polymer B1 | 40.0 | 1.9 | 30.05 | 28.0 | 0.05 | 0.045 | 100 | 10.2 |
| | 4 | I-1 | 1 | silver | 33 | Polymer B1 | 40.0 | 1.9 | 30.05 | 28.0 | 0.05 | 0.045 | 100 | 10.2 |
| | 5 | I-1 | 1 | silver | 33 | Polymer B1 | 40.0 | 1.9 | 30.05 | 28.0 | 0.05 | 0.045 | 100 | 10.2 |
| | 6 | I-2 | 1 | silver | 33 | Polymer B1 | 40.0 | 1.9 | 30.05 | 28.0 | 0.05 | 0.045 | 84 | 10.2 |
| | 7 | I-3 | 2 | silver | 51 | Polymer B1 | 40.0 | 1.1 | 30.05 | 28.8 | 0.05 | 0.027 | 100 | 13.3 |
| | 8 | I-4 | 3 | silver | 26 | Polymer B1 | 40.0 | 7.6 | 30.05 | 22.3 | 0.05 | 0.160 | 100 | 9.2 |
| | 9 | I-5 | 4 | nickel | 39 | Polymer B1 | 40.0 | 1.9 | 30.05 | 28.0 | 0.05 | 0.045 | 100 | 11.7 |
| | 10 | I-1 | 1 | silver | 33 | Polymer B1 | 40.0 | 1.9 | 30.05 | 28.0 | 0.05 | 0.045 | 100 | 10.2 |
| | 11 | I-1 | 1 | silver | 33 | Polymer B1 | 40.0 | 1.9 | 30.05 | 28.0 | 0.05 | 0.045 | 100 | 10.2 |
| | 12 | I-1 | 1 | silver | 33 | Polymer B1 | 40.0 | 1.9 | 30.05 | 28.0 | 0.05 | 0.045 | 100 | 10.2 |
| | 13 | I-6 | 1 | silver | 34 | Polymer B1 | 40.0 | 1.9 | 30.05 | 28.0 | 0.05 | 0.045 | 92 | 11.1 |
| Comparative Example | 1 | I-C1 | C1 | silver | 38 | tannic acid | 40.0 | 2.0 | 30.05 | 27.9 | 0.05 | 0.048 | 100 | 12.5 |
| | 2 | I-C2 | C2 | silver | 8 | Polymer B1 | 40.0 | 2.3 | 30.05 | 27.6 | 0.05 | 0.054 | 100 | 9.1 |
| | 3 | I-C3 | C3 | silver | 67 | Polymer B1 | 40.0 | 0.8 | 30.05 | 29.1 | 0.05 | 0.020 | 100 | 13.8 |
| | 4 | I-1 | 1 | silver | 33 | Polymer B1 | 40.0 | 1.9 | 30.05 | 28.0 | 0.05 | 0.045 | 100 | 10.2 |
| | 5 | I-1 | 1 | silver | 33 | Polymer B1 | 40.0 | 1.9 | 30.05 | 28.0 | 0.05 | 0.045 | 100 | 10.2 |

| | | | | | | | | | | | | | | |
|---|---|---|---|---|---|---|---|---|---|---|---|---|---|---|
| *1: Propylene glycol (The content (% by mass) in table includes the content carried in by Surfynol 104PG-50) *2: Surfynol 104PG-50 (The content (% by mass) in table is the active ingredient) *3: Mass ratio ((polymer B)/((metallic fine particles A)+(polymer B))) | | | | | | | | | | | | | | |

**Table 2**

| | | Heating temperature in sintering step (°C) | Composite material | | | | | Evaluation | | | |
|---|---|---|---|---|---|---|---|---|---|---|---|
| | | | Substrate | | Metal film | | | Hue change | | | Electrochemical migration |
| | | | Kind | Heat resisting temperature (°C) | Cross-sectional porosity (% by area) | Content of metal (% by mass) | Thickness (µm) | L* value before storing (SCI) | L* value after storing (SCI) | Change rate of L* value before and after storing (%) | Time (t) (h) |
| | 1 | 70 | GL-101A450 | 70 | 4 | 99 | 1.0 | 92 | 91 | 99 | 1200 |
| | 2 | 70 | GL-101A450 | 70 | 7 | 97 | 0.10 | 87 | 85 | 98 | 980 |
| | 3 | 70 | GL-101A450 | 70 | 9 | 94 | 52.0 | 86 | 85 | 99 | 930 |
| | 4 | 70 | GL-101A450 | 70 | 3 | 98 | 0.7 | 89 | 86 | 97 | 1000 |
| | 5 | 70 | GL-101A450 | 70 | 18 | 98 | 1.9 | 82 | 76 | 93 | 910 |
| | 6 | 70 | GL-101A450 | 70 | 21 | 97 | 1.2 | 80 | 77 | 96 | 1040 |
| Example | 7 | 70 | GL-101A450 | 70 | 14 | 96 | 0.9 | 90 | 89 | 99 | 990 |
| | 8 | 70 | GL-101A450 | 70 | 18 | 94 | 1.5 | 88 | 85 | 97 | 1050 |
| | 9 | 70 | GL-101A450 | 70 | 8 | 98 | 1.1 | 84 | 81 | 96 | 1020 |
| | 10 | 80 | GL-101A450 | 70 | 5 | 96 | 1.0 | 90 | 88 | 98 | 1150 |
| | 11 | 95 | GL-101A450 | 70 | 25 | 98 | 1.3 | 78 | 71 | 91 | 950 |
| | 12 | 70 | GL-101A450 | 70 | 9 | 92 | 1.2 | 76 | 70 | 92 | 970 |
| | 13 | 70 | GL-101A450 | 70 | 7 | 98 | 1.1 | 85 | 83 | 98 | 1080 |
| Comparative Example | 1 | 70 | GL-101A450 | 70 | 17 | 98 | 1.1 | 79 | 48 | 61 | 540 |
| | 2 | 70 | GL-101A450 | 70 | 9 | 97 | 1.0 | 81 | 72 | 89 | 400 |
| | 3 | 70 | GL-101A450 | 70 | 8 | 98 | 1.0 | 89 | 72 | 81 | 440 |
| | 4 | 100 | GL-101A450 | 70 | 34 | 98 | 1.4 | 66 | 51 | 77 | 380 |
| | 5 | 4 | GL-101A450 | 70 | 11 | 86 | 1.1 | 69 | 56 | 81 | 410 |

It is understood from Table 2 that Examples 1 to 13 can provide a composite material including a metal film that suffers less hue change, and is suppressed in occurrence of electrochemical migration, as compared to Comparative Examples 1 to 5.

### Industrial Applicability

The present invention can provide a composite material including a metal film that suffers less hue change, and is suppressed in occurrence of electrochemical migration. Accordingly, the method of producing a composite material of the present invention can be favorably applied to devices used in various fields.

## Claims

1. A method of producing a composite material comprising a substrate and a metal film formed on the substrate, comprising
a step of coating a metallic fine particle-containing ink on the substrate to form a metal film on the substrate,
the substrate having a heat resisting temperature of 130°C or less,
the metallic fine particle-containing ink comprising metallic fine particles A dispersed with a polymer B, the metallic fine particles A having a volume average particle diameter D_{A} of 10 nm or more and 60 nm or less,
the metal film having a cross-sectional porosity of 2% by area or more and 30% by area or less, and
the metal film having a content of a metal of 90% by mass or more.

2. The method of producing a composite material according to claim 1, wherein the metal film has a thickness of 0.05 pm or more and 60 pm or less.

3. The method of producing a composite material according to claim 1 or 2, wherein a metal element comprised in the metallic fine particle-containing ink has a proportion of a reduced metal of 80% by mass or more.

4. The method of producing a composite material according to any one of claims 1 to 3, wherein a metal constituting the metallic fine particles Acomprises at least one kind selected from the group consisting of gold, silver, copper, nickel, and palladium.

5. The method of producing a composite material according to any one of claims 1 to 4, wherein the metallic fine particle-containing ink has a mass ratio ((polymer B)/((metallic fine particles A)+(polymer B))) of a content of the polymer B with respect to a total content of the metallic fine particles A and the polymer B of 0.01 or more and 0.2 or less.

6. The method of producing a composite material according to any one of claims 1 to 5, wherein the metallic fine particle-containing ink has a content of the metallic fine particles A of 2% by mass or more and 85% by mass or less.

7. The method of producing a composite material according to any one of claims 1 to 6, wherein the polymer B is a vinyl-based polymer comprising a constitutional unit derived from a monomer (b-1) having a carboxy group and a constitutional unit derived from a monomer (b-2) having a polyoxyalkylene group.

8. The method of producing a composite material according to any one of claims 1 to 7, wherein the metallic fine particle-containing ink comprises at least one kind selected from the group consisting of a diol and a triol as an organic solvent C.

9. The method of producing a composite material according to any one of claims 1 to 8, wherein the metallic fine particle-containing ink has a viscosity at 25°C of 3 mPa·s or more and 15 mPa s or less.

10. The method of producing a composite material according to any one of claims 1 to 9, wherein the substrate is at least one kind selected from the group consisting of a paper substrate and a substrate formed of a resin.

11. The method of producing a composite material according to any one of claims 1 to 10, wherein the method further comprises, after coating the metallic fine particle-containing ink on the substrate, a sintering step of sintering the metallic fine particles A in an ink film on the substrate, and a sintering treatment temperature is a heat resisting temperature of the substrate + 15°C or less.

12. The method of producing a composite material according to claim 11, wherein a sintering treatment time is 15 minutes or more and 180 minutes or less.

13. The method of producing a composite material according to claim 11 or 12, wherein a sintering treatment pressure is 1 kPa or more and 150 MPa or less.

14. The method of producing a composite material according to any one of claims 1 to 13, wherein the metallic fine particle-containing ink is coated on the substrate by an ink-jet printing method.

15. A device comprising a composite material produced by the production method according to any one of claims 1 to 14.
